# EUROPEAN PATENT SPECIFICATION

(11) **EP 2 375 443 B1**
(45) Date of publication and mention of the grant of the patent: **29.07.2020**
(21) Application number: 11173320.0
(22) Date of filing: 14.10.2004
(51) Int. Cl.: H01L 21/762, H01L 21/304

(54) **Method for preparing and assembling substrates**
Verfahren zum Herstellen und Zusammenbauen von Substraten
Procédé de préparation et d'assemblage de substrats

(30) Priority: 14.10.2003 FR 0350674; 07.05.2004 US 568700 P
(43) Date of publication of application: 12.10.2011
(62) Divisional of application: 04791232.4
(73) Proprietor: Soitec, 38190 Bernin (FR)
(72) Inventor: Aspar, Bernard, 38140 Rives (FR); Lagahe-Blanchard, Chrystelle, 38134 Saint Joseph De Rivière (FR)
(74) Representative: Ilgart, Jean-Christophe

(56) References cited:
- EP-A- 1 026 728
- EP-A- 1 059 663
- EP-A- 1 189 266
- JP-A- 11 354 761
- JP-A- 2000 173 961
- US-A1- 2002 187 595
- US-B1- 6 309 950

## Description

### Technical field and prior art

The invention relates to the field of assembling wafers or slices or layers of material, notably semiconductors, and of their preparation with the purpose of assembling them.

Among the assembly techniques of such substrates, molecular adhesion allows to assemble flat structures of low surface roughness.

It allows to obtain unique structures and is particularly well adapted for bonding together wafers of material used in microelectronics, such as, for example, wafers in silicon, or III-V material (AsGa, InP) or glass or fused silica or vitreous fused silica glass substrates.

Nowadays this technique is used industrially, for example in the manufacture of SOI (Silicon On Insulator) material.

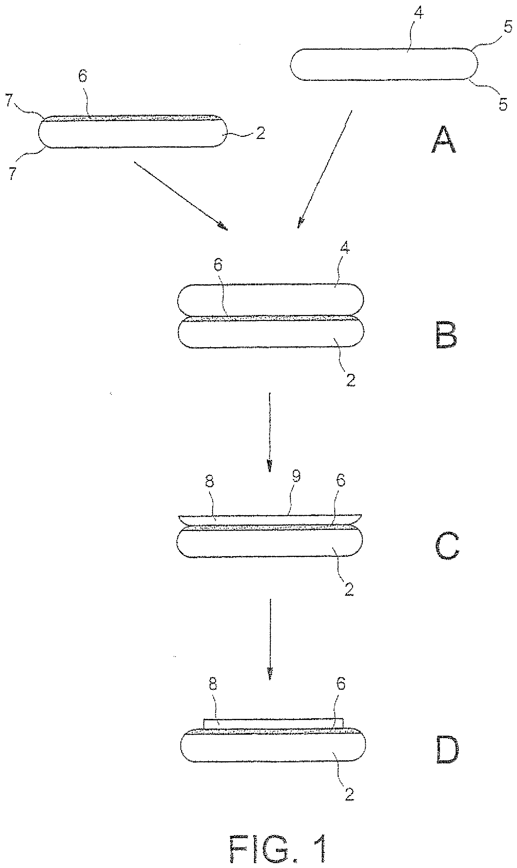

The known methods for manufacturing SOI material, which use molecular adhesion, implement two wafers 2, 4 of silicon (figure 1, part A), of which at least one of the two has a layer 6 of oxide on the surface.

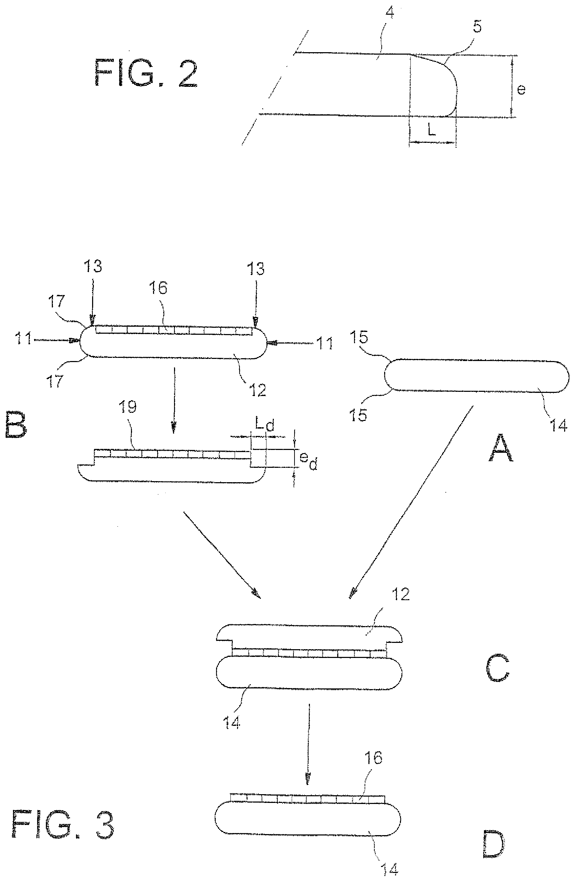

These two wafers are of standard size. The edges 5 and 7 are generally chamfered, so as to avoid fractures likely to appear during eventual manufacturing of components or in the event of shocks to still sharp edges. There are rounded and/or bevelled chamfers. Figure 2 represents, in greater detail, an example of a chamfer zone 5, of width L (measured on a plane parallel to the mean plane P of the wafer) of a wafer 4, of thickness e.

The assembling firstly comprises a surface preparation stage, a putting together stage (figure 1, part B), generally followed by a heat treatment stage.

Normally, this heat treatment is performed at 1100°C for 2 hours for SOI substrates.

Then, as illustrated in figure 1, part C, at least one of the two wafers is thinned out via surface edge grinding and/or mechanical polishing and/or mechano-chemical polishing.

The chamfers 5 and 7 generate the existence of a non-bonded zone on the wafer edges.

After thinning out, a membrane 8 made in silicon remains bonded to the centre, but detached on the edges, as visible in figure 1, part C.

The detached edge of the membrane must be removed, as it is likely to break in an uncontrolled manner and introduce particles on the other surfaces, and notably on surface 9 of the membrane 8, or on components made in the membrane 8.

For this reason a stage for routing or eliminating matter in the peripheral zone is performed in order to eliminate this edge zone from the membrane 8, as illustrated in figure 1, part D.

This routing is normally performed via mechanical means.

This stage is very delicate. For example, in the event of mechanical machining, it is difficult to route or trim everything and to stop exactly at the bonding interface, which in this case is the upper surface of the oxide layer 6. Indeed, either we stop just above this interface leaving some matter above the latter, or we stop in the support 2 and the surface polish of the edges of the front face of the support is lost.

It is therefore important to find a means of properly and accurately routing or trimming a wafer of material.

This phenomenon is also important in the case where at least one of the two wafers contains all or part of an electronic or opto-electronic device, or a micro-system, or a nano-system or another component.

The same problem exists if the assembling of the two wafers is done via bonding instead of molecular adhesion, or even without the oxide layer 6 on the surface of the wafer 12.

Another problem is the marking of one or both of the two wafers 2 and 4, generally on the support wafer, with the purpose of providing specific information such as for example identification information of a batch. For example, on SOI wafers, due to their multilayer nature, a marking, generally via etching, induces a greater number of particles than on bulk wafers.

Document EP 1 059 663 A discloses a method for assembling an epitaxial layer grown on a porous layer of a first bulk silicon wafer with a second supporting wafer . In this document, the method comprises: the step of covering the epitaxial layer with a protective layer; the step of trimming the periphery of the epitaxial layer, said trimming starting from the face of the epitaxial layer to be assembled with the second wafer; the step of eliminating the protective layer after trimming of the epitaxial layer; and then, an assembling stage of the trimmed epitaxial layer located over the first wafer and of the second wafer.

Document EP 1 026 728 A discloses a method for assembling an epitaxial layer grown on a porous layer of a first bulk silicon wafer and a second supporting wafer. In this document, the method comprises: the step of covering the epitaxial layer with a protective layer; a trimming stage of the chamfered edge of the epitaxial layer, said trimming stage starting from the face of the epitaxial layer to be assembled with the second wafer; the step of eliminating the protective layer after the trimming stage of the epitaxial layer; then, an assembling step of the trimmed epitaxial layer located over the first wafer and of the second wafer.

### PRESENTATION OF THE INVENTION

The invention firstly relates to a method for assembling a first bulk wafer and a second bulk wafer of material, according to claim 1.

According to the invention, a trimming stage of the matter in a peripheral section of at least the first wafer, is thus performed before bonding or assembling the two wafers together.

A thinning out stage of at least the first wafer can then be carried out, leaving a layer on the second wafer. A transplanting or transferring of this layer is thus achieved.

The first wafer of the method according to the invention is a chamfered wafer, bearing at least one chamfered edge. The routing or trimming thus relates to at least a part of the chamfered edge. It can also eat into a part, normally peripheral, of a transplant or transfer layer.

The method for assembling according to the invention thus allows to obtain a structure with a first bulk and chamfered wafer, perfectly trimmed before assembling, the trimming being devoid of the problems developed above in the context of the prior art, problems due to the existence of a second wafer.

The trimming stage before assembling can be performed before or after possible surface preparation stages with the purpose of assembling or transplanting.

The first wafer can be trimmed through its entire thickness, or through its lesser thickness, for example equal to or greater than the final thickness of the layer that is sought after or transplanted onto the second wafer.

According to an alternative, the trimming can also be performed over a thickness that is less than this final thickness.

In this case, it could be beneficial to end the trimming, in a standard manner, after assembling, with one or other of the two faces of the first wafer.

If the substrates or wafers have comparable initial dimensions or initial diameters, the thickness of the trimming can be such that the routed wafer has, after trimming, a dimension or diameter less than the other wafer.

Preferably, in the case where the first wafer has a rollover edge or chamfer, the width, measured on the plane of the wafer, on which the upper wafer is trimmed, is greater than or equal to the width of the rollover or chamfer.

It can also have a width greater than or equal to the width of the zone which can not be bonded or assembled due to the rollover or chamfer.

The first wafer can have a zone or a weakened or cleavage or fracture plane, created in depth for example by hydrogen implantation or by the creation of a buried porous zone or by the creation of a removable bonding interface.

When the thickness of the trimmed zone is greater than the thickness of the desired thin layer, this routed wafer can be recycled, without the need of routing before bonding onto a new substrate. A new weakened a cleavage or fracture plane can thus be created, then it can be directly assembled with a new substrate.

The assembling of the two wafers is performed via bonding, through the adding of matter such as for example adhesive or wax.

The trimming stage can be performed in a regular manner around the first wafer.

It can also be performed in an irregular manner around the first wafer, creating one or more flats or flat surfaces.

The trimming stage can also be performed in an irregular manner, creating at least one marking zone in at least one of the wafers. A marking stage in at least one of these marking zones can then be carried out.

### BRIEF DESCRIPTION OF THE FIGURES

Figure 1, parts A-D, represents stages of a known method for assembling substrates.
Figure 2 represents a part of a substrate and its edge or rollover edge.
Figure 3, parts A-D, represents stages forming part of a method according to the invention.
Figures 4, parts A-C, and 5, parts A-B, represent alternative steps forming part of a method according to the invention.
Figure 6, parts A-E, represents alternative steps forming part of a method according to the invention, in the case of a substrate with a weakened plane.
Figure 7, parts A-D, represents alternative steps forming part of a method according to the invention, in the case of a substrate with a protective or bonding layer.
Figures 8A-8D represent a front view of the routed or trimmed wafers.
Figure 9 represents a wafer of material with a lateral shoulder.
Figures 10A-10B represent a wafer with an embedding.

### EXAMPLES OF EMBODIMENTS OF THE INVENTION

Figure 3, parts A-D, represents stages forming part of a method according to the invention.

Two wafers 12 and 14 are chosen, for example two wafers of semiconductor material, such as standard silicon wafers.

These wafers can typically have a thickness of between 300 µm and 800 µm. They are for example wafers of 100 mm or 200 mm or 300 mm in diameter.

For the aforementioned reasons, the edges 15 and 17 are chamfered.

Components or circuits 16 are represented in the wafer 12, but the invention relates to the case of a wafer 12 absent of any circuit, the reference 16 thus designating a layer of material to be transplanted or transferred onto the wafer 14. In figure 3, part B, the surface of this layer 16 of material to be transplanted or transferred lies flush with the surface of the wafer 12.

A routing or matter eliminating or trimming stage is then performed (figure 3, part B), starting from the face 19 of the wafer 12 (thus following a direction indicated by the arrows 13) to be assembled with the wafer 14, over a thickness ed and a width Ld. It is also possible to perform a routing or trimming in the direction indicated by the arrows 11, that meaning substantially parallel to the principal plane of the wafer 12. A routing or trimming in the two combined directions is also possible.

The width Ld is measured on a plane parallel to the mean plane of the wafer. This routing or trimming stage, performed before the assembling or transplanting stage onto the wafer 14, allows to eliminate, at least partially and from the assembly face 19 or from its lateral edges, the matter located in the peripheral zone, or located around the transplant layer 16, zone which is likely to have problems caused by the non-bonded edges.

Ld is greater than or equal to the width L of the rollover edge or the chamfer (figure 2). It can be from about a few hundred µm to a few mm, for example of between 100 µm and 5 mm.

Ld is notably greater than L in the case where the non-bonding zone or zone which can not adhere to a substrate after assembling, as illustrated in stage C of figure 1, is itself greater than L.

Indeed, this "non-bonding" or "non-assembling" zone depends on the manner the rollover edge is made on the wafer 12 but also on the wafer 14.

It can also depend on the technical stages that could have been previously performed on the upper wafer 12 and on the support wafer 14. Regarding the width L, some stages can increase the width of this non-bonded zone (for example oxidising or depositing stages), others can reduce this said width (for example a levelling or flattening or polishing stage).

Ld can therefore be greater than or equal to the width of this non-bonding or non-assembling zone.

The thickness ed will be less than the thickness e of the wafer. It can be substantially equal to or greater or lesser than the thickness of the layer 16 (stage D, figure 3) or of the membrane to be obtained after the future thinning out or transplanting stage onto the wafer 14.

By way of example ed can be about a few µm or between 1 µm (or 10 µm) and 100 µm or even between 5 µm and 60 µm. As for the layer 16, it can have a thickness, for example, between 1 µm and 60 µm.

If ed is less than the thickness of the layer 16 (stage D, figure 3) or of the membrane to be obtained after the future thinning out or transplanting stage, then the assembling stage can be followed by an additional routing or trimming of the remaining section of substrate 12, as will be explained below.

The routing or trimming stage before assembling can be performed in a mechanical and/or chemical (notably humid) and/or mechano-chemical manner and/or via plasma. The mechanic routing can be performed for example via "edge grinding" or "edge polishing".

It then proceeds with the assembling of the two wafers (stage C, figure 3) for example via molecular adhesion.

As explained above, the assembling comprises for example a surface preparation stage, a putting into contact stage and a heat treatment stage.

This heat treatment stage is performed at a few hundred degrees Celsius, for example between 100 and 1200°C, or even 1100°C, and this for a time span from a few minutes to a few hours, for example between 10 minutes and 3 hours, or even 2 hours.

Then, as illustrated in figure 3 (stage D), at least one of the two wafers is thinned down to the desired thickness, for example over a thickness greater than or equal to e-ed, via edge grinding and/or mechanical polishing and/or mechano-chemical polishing and/or chemical polishing. In figure 3 (stage D), the thinned wafer is the previously routed wafer 13.

After thinning out of the latter, a membrane made in semiconductor material thus remains bonded or assembled to the wafer 14, towards its centre. There are no lateral membranes nor any non-bonded lateral residue. The transplanting or transferring of the layer 16 is thus better than with the technology of the prior art.

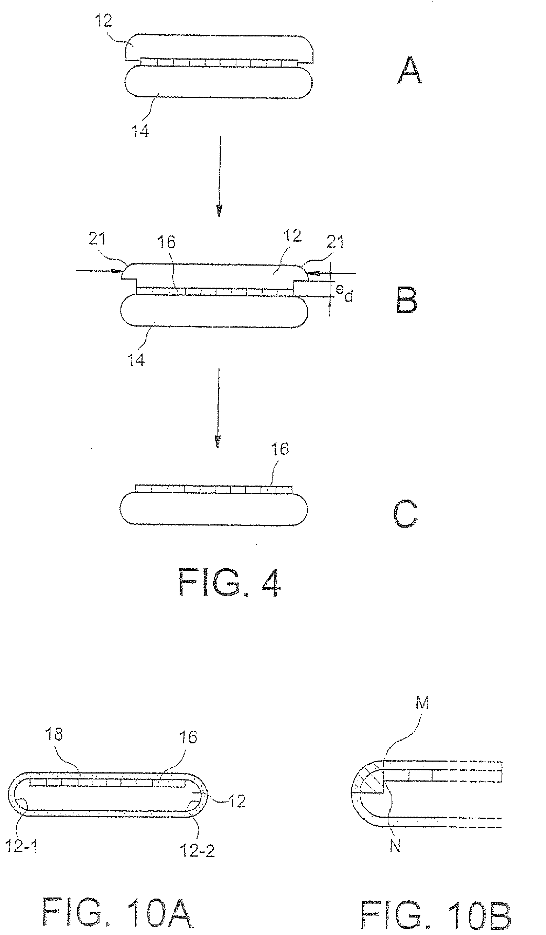

Figure 4, part A, corresponds to the aforementioned case where the depth ed over which the wafer 12 was routed before assembling is insufficient to completely remove the layer 16 during the thinning out stage.

Assembling, which has led to the structure of figure 4, part A, can thus be followed with an additional routing or trimming, from the edges 13 located on the side of the front face or from the assembling face, in order to obtain a routed zone over a thickness ed greater than that of the layer 16 (figure 4, part B).

It is also possible to perform this additional routing or trimming from the edges 21 located on the rear face, opposite the assembling face, or even laterally, in the direction of the arrows 11 indicated in figure 4B.

This additional routing or trimming stage is free of the problems disclosed in the introduction to this application: there is notably no risk of spoiling or etching out the substrate 14. It can then be followed by the thinning out stage of the substrate 12, as described above (figure 4, part C).

Here again we obtain a transplant or a transfer free of membrane or lateral residue.

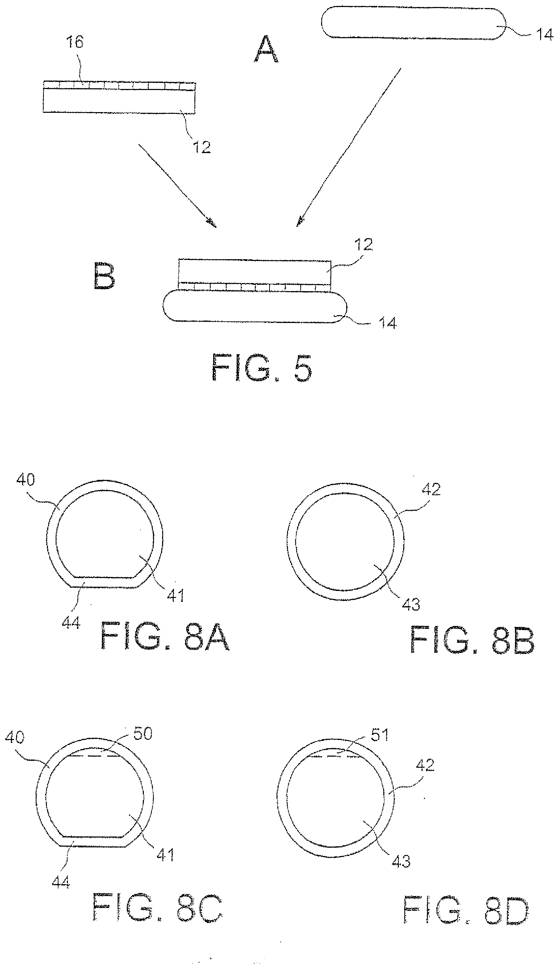

According to an alternative, the wafer 12 is completely routed over its entire thickness (figure 5, part A). This is the case where ed=e.

The assembling stage leads to the device represented in figure 5, part B, which can then be thinned out as explained above.

The wafer 12 then has a width or diameter less than that of the wafer 14.

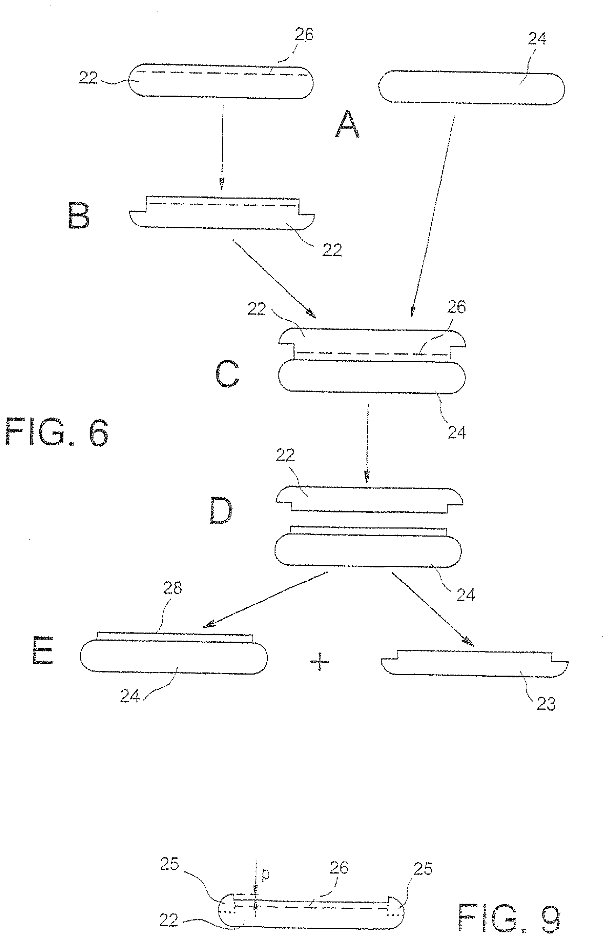

Figure 6 illustrates an initial substrate 22 in which a weakened or fracture plane 26 was made, for example via previous ion implantation (for example a hydrogen implantation), as explained for example in the document by S.S.Iyer and al. "Silicon wafer bonding technology for VLST and MEMS applications", published by INSPEC, 2002, Antony Rowe Ltd, or via creating a removable bonding interface.

It then proceeds with the routing or trimming of this substrate (figure 6, part B) over a part of its thickness or over all of its thickness, as explained above, then with the assembling of the two substrates 22 and 24.

For example, a heat treatment allows to separate the substrate 22 on the ion implantation layer 26 of hydrogen ions (figure 6, part D).

This results, on one hand in a unit made of the substrate 24 with a superficial layer 28 of material which comes from the initial substrate 22, and on the other hand in a substrate or a free portion 23 which also comes from the initial substrate 22 and which is reusable for subsequent operations. If the thickness over which the substrate 22 was routed or trimmed is greater than the thickness of the transplant layer 28, this substrate 22 can notably be subjected to a new ion or atom implantation, then a new transferring or transplanting stage after assembling with a new substrate 24, but without the need to perform a new routing or trimming stage.

The methods that are described above in connection with one of the figures 3-6 also apply in the case where the initial substrate 12 and 22 has the shape illustrated in figure 9, with a shoulder 25 on the edges of the wafer.

These shoulders define a stiffening located at a depth P, for example lying between 50 nm and 2 µm.

The routing stage allows to remove these shoulders. An ion implantation stage, for the creating of a weakened plane 26, can take place before or after this routing or trimming stage: a wafer is thus obtained which is identical to the one represented in part B of figure 6. The following stages in figure 6 can thus be performed as described above.

BSOI or thick SOI type structures can also be created in an efficient manner. The thinning out stage is then mechanic and/or mechano-chemical.

According to an example not covered by the invention, electronic components are made in a wafer such as the wafer 12 (figure 3A) over a superficial thickness, for example, between 1 and 10 µm.

We rout or trim via "surface edge grinding" the edge of the wafer over a thickness ed of 50 µm and along a width Ld of 3 mm.

This routing stage can be performed before surface preparation (for example via mechano-chemical levelling followed by chemical cleaning) and in order to reduce the number of cleansings before assembling.

Then the routed wafer (comprising the components) is bonded via molecular adhesion onto the support wafer. The structure is then annealed for example at a temperature of 300°C and for a time span of between a few minutes and a few hours.

The superficial wafer is then thinned out via surface edge grinding and mechano-chemical (figure 3, part D) and/or chemical polishing until a thickness de is obtained, for example, 10 µm.

A transplanted layer, comprising the components, transferred onto a support wafer is thus obtained.

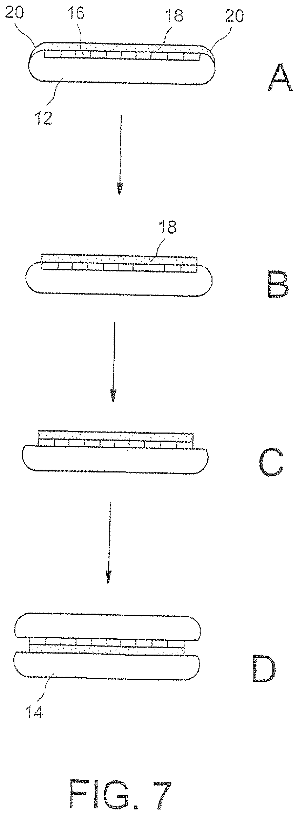

In figure 7, part A, the wafer 12 comprises components 16 and is covered on its surface with a protective layer 18, for example an oxide layer 18 (figure 7, part A). This can also be a bonding layer.

A crown 20 is defined via lithography which will correspond to the routing zone. A local chemical etching allows to eliminate, on this zone, the protective layer 18 (figure 7, part B).

The edge of the substrate 12 is then etched (figure 7, part C), for example via chemical (ex. TMAH) or plasma etching.

The wafer is then cleaned, for example via chemical cleaning. According to an alternative, the cleaning is integrated into the chemical etching.

It can then proceed with the assembling on a wafer 14 as explained above (figure 7, part D).

In figure 10A and 10B, a protective layer 18 initially coats the entire upper section of the wafer 12 as well as the edges 12-1 and 12-2, and possibly its lower section (in which case it coats the entire wafer).

The routing operation will allow to eliminate the lateral zones of this wafer such as the hatched zone in figure 10B. A possible scaling or clearing due to the routing operation occurs at the point M of the coating layer 18 or in a zone of this layer near this point. A scaling occurring on the wafer can generate defects, some of which can show on the surface of the wafer. A point of the surface to be assembled, such as point N, remains intact despite routing. The protective layer 18 can be eliminated after routing and before assembling.

Figures 8A-8D each represent a front view of a wafer 40 and 42 with a layer 41 and 43 of material around which routing was performed. This layer 41 and 43 is intended to be transplanted or transferred onto a second wafer, according to any one of the aforementioned embodiments. In figure 8A the wafer has a flat or a flattered zone 44.

An irregular routing can be performed, as illustrated in figures 8C-8D. In these figures, the zones 50 and 51 represent zones or flats or flat surfaces which will allow to mark the support wafer. The zone 44 in figure 8A can also be used to mark the wafer.

Such a zone allows to provide indications regarding the nature of the wafer or an identification number of a batch to which the wafer belongs.

In particular, one of the wafers has a chamfered edge, the routing can thus take place over a width at least equal to the width of the chamfered edge, measured on a plane parallel to that of the wafer.

The assembling takes place via bonding.

Generally, the invention has the advantage of being able to be integrated into a method for manufacturing. The method set forth in the invention is also well suited to the manufacturing of BSOI type material, or even to the transplanting of a layer of III-V material onto silicon for example.

In the case of BSOI a wafer of silicon is first oxidised in order to obtain a layer of silicon dioxide, which will serve as buried oxide.

This wafer is then routed over a 1.5 mm wide zone which corresponds to the edge or the rollover edge of the wafer, as explained above.

The surface of the wafer is then cleaned, for example via chemical and/or mechano-chemical cleaning stages.

Its surface is bonded via molecular adhesion onto a second wafer, made in silicon, and the unit is annealed at 1100°C for 2 hours.

A surface edge grinding stage followed by a mechano-chemical polishing allows to thin the wafer down to the desired thickness in order to obtain the SOI substrate.

This said method can apply to the transplanting of III-V material such as AsGa or InP onto another material such as a semiconductor notably silicon.

This said method can also apply to the transplanting of semiconductor material such as Germanium or Germanium silicon (SiGe) onto a substrate made in another material such as a semiconductor, notably silicon.

Likewise, this method can be used to perform a transplanting of wafers of non-semiconductor material, for example wafers of insulating material such as glass or quartz, or piezoelectric material such as LiNbO3 or LiTaO3, which allows to obtain a perfectly routed thin film on a support of the same nature or of a different nature, for example a semiconductor substrate and notably silicon.

The wafers of material prepared and assembled according to the invention are wafers of "bulk" material.

## Claims

1. Method for assembling a first bulk wafer (12, 22) and a second bulk wafer (14, 24), of which at least the first bulk wafer, known as chamfered wafer, has at least a chamfered edge (7, 17) comprising:
- covering the first wafer with a protective layer (18),
- a trimming stage of at least one part of the chamfered edge of the first wafer (12, 22) over a width Ld, measured on a plane parallel to that of the first wafer, at least equal to the width L of the chamfered edge, measured on the same plane and/or at least equal to the width of the zone of this first wafer which cannot, without trimming, be bonded with the second wafer, said trimming starting from said face of the first wafer to be assembled with the second wafer;
- eliminating the protective layer (18) after trimming of the first wafer,
- then, a bonding stage of the first wafer, trimmed, and of the second wafer.

2. Method as in claim 1, further comprising, after bonding, a thinning out stage of at least the first wafer, leaving at least a layer (16) on the second wafer.

3. Method as in one of claims 1 or 2, the trimming stage being performed:
- over the entire thickness e of the first wafer,
- or over a thickness ed less than the thickness e of the first wafer;
- or over a thickness ed less than the thickness e of the first wafer and greater than or equal to a thickness of a layer (16, 28) of the first wafer to be transplanted onto the second wafer;
- or over a thickness ed less than the thickness e of the first wafer and less or equal to a thickness of a layer (16, 28) of the first wafer to be transplanted or transferred onto the second wafer;
- and/or over a thickness ed of the first wafer of between 1 µm and 100 µm.

4. Method as in one of claims 1 to 3, the second wafer being chamfered and comprising at least a chamfered edge (5).

5. Method as in any of claims 1 to 4, the trimming stage of the first wafer being performed
- over a width Ld, measured on a plane parallel to that of the first wafer, of between 100 µm and 5 mm.

6. Method as in any of the previous claims,
the first wafer having a weakened plane (26) defining a thin layer in the wafer, for example via ion implantation or via the creating of a removable bonding interface, the first wafer being routed over a thickness greater than that of the thin layer, the assembly stage being possibly followed by:
- a thinning out stage via separation of the first wafer along the weakened plane, so as to leave the thin layer on the second wafer and leave a free portion (23) of the first substrate;
- a new creating stage of a new weakened plane in the portion (23) that remained free of the first substrate;
- a bonding stage of this portion (23) with a third substrate.

7. Method as in any of claims 1 to 6, the first wafer comprising a lateral shoulder (25), eliminated during the trimming stage.

8. Method as in any of claims 1 to 7, the assembling of the two substrates being performed via molecular adhesion or via bonding using an adhesive substance.

9. Method as in any of the previous claims, the trimming being performed via mechanical or chemical or mechano-chemical etching or polishing or via plasma etching or via a combination of at least two of these types of etching, before, or after, a previous surface preparation stage of the first wafer with the purpose of bonding or transplanting.

10. Method as in any of the previous claims, at least one of the two wafers being made in a semiconductor material, for example being made in silicon or in a III-V type semiconductor material, or in Germanium or in Germanium silicide (SiGe) or in a piezoelectric material or in an insulating material.

11. Method as in any of the previous claims, the trimming stage being performed in a regular manner around the first wafer, or in an irregular manner around the first wafer so that a plane (44) is created or a marking zone (50,51) is created.

## Patentansprüche

1. Verfahren zum Zusammenfügen eines ersten Bulkwafers (12, 22) und eines zweiten Bulkwafers (14, 24), von denen wenigstens der erste Bulkwafer, bekannt als abgeschrägter Wafer, wenigstens eine abgeschrägte Kante (7, 17) hat, umfassend:
- Bedecken des ersten Wafers mit einer Schutzschicht (18),
- einen Abgratungsschritt von wenigstens einem Teil der abgeschrägten Kante des ersten Wafers (12, 22) über eine Breite Ld, gemessen in einer Ebene parallel zu jener des ersten Wafers, die wenigstens gleich der Breite L der abgeschrägten Kante ist, gemessen in der gleichen Ebene und/oder wenigstens gleich der Breite der Zone dieses ersten Wafers, die ohne Abgratung nicht mit dem zweiten Wafer verbunden werden kann, wobei die Abgratung von der Fläche des ersten Wafers beginnt, die mit dem zweiten Wafer zusammenzufügen ist;
- Entfernen der Schutzschicht (18) nach dem Abgraten des ersten Wafers,
- dann einen Verbindungsschritt des ersten abgegrateten Wafers und des zweiten Wafers.

2. Verfahren nach Anspruch 1, ferner umfassend nach dem Verbinden einen Abdünnungsschritt wenigstens für den ersten Wafer, der wenigstens eine Schicht (16) auf dem zweiten Wafer übrig lässt.

3. Verfahren nach einem der Ansprüche 1 oder 2, wobei der Abgratungsschritt durchgeführt wird:
- über die gesamte Dicke e des ersten Wafers,
- oder über eine Dicke ed, die kleiner ist als die Dicke e des ersten Wafers;
- oder über eine Dicke ed, die kleiner ist als die Dicke e des ersten Wafers und größer oder gleich einer Dicke einer Schicht (16, 28) des ersten Wafers, die auf den zweiten Wafer zu transplantieren ist;
- oder über eine Dicke ed, die kleiner ist als die Dicke e des ersten Wafers und kleiner oder gleich einer Dicke einer Schicht (16, 28) des ersten Wafers, die auf den zweiten Wafer zu transplantieren oder zu transferieren ist;
- und/oder über eine Dicke ed des ersten Wafers zwischen 1 µm und 100 µm.

4. Verfahren nach einem der Ansprüche 1 bis 3, wobei der zweite Wafer abgeschrägt ist und wenigstens eine abgeschrägte Kante (5) umfasst.

5. Verfahren nach einem der Ansprüche 1 bis 4, wobei der Abgratungsschritt des ersten Wafers durchgeführt wird über eine Breite Ld, gemessen in einer Ebene parallel zu jener des ersten Wafers, zwischen 100 µm und 5 mm.

6. Verfahren nach einem der vorhergehenden Ansprüche,
wobei der erste Wafer eine abgeschwächte Ebene (26) hat, die eine dünne Schicht in dem Wafer definiert, beispielsweise mittels Ionenimplantation oder mittels der Erzeugung einer entfernbaren Verbindungsgrenzfläche, wobei der erste Wafer über eine Dicke größer als jene der dünnen Schicht gefräst wird, wobei auf den Zusammenfügungsschritt möglicherweise Folgendes folgt:
- ein Abdünnungsschritt mittels Separation des ersten Wafers entlang der abgeschwächten Ebene derart, dass die dünne Schicht auf dem zweiten Wafer übrig gelassen wird und ein freier Bereich (23) auf dem ersten Substrat übrig gelassen wird;
- ein Neuerzeugungsschritt einer neuen abgeschwächten Ebene in dem Bereich (23), der bei dem ersten Substrat frei geblieben ist;
- einen Verbindungsschritt dieses Bereichs (23) mit einem dritten Substrat.

7. Verfahren nach einem der Ansprüche 1 bis 6, wobei der erste Wafer eine laterale Schulter (25) umfasst, die während des Abgratungsschritts entfernt wird.

8. Verfahren nach einem der Ansprüche 1 bis 7, wobei das Zusammenfügen der zwei Substrate mittels molekularer Adhäsion oder mittels einer Verbindung unter Verwendung einer Haftsubstanz durchgeführt wird.

9. Verfahren nach einem der vorhergehenden Ansprüche, wobei die Abgratung mittels mechanischen oder chemischen oder mechanisch-chemischen Ätzens oder Polierens oder mittels Plasmaätzen oder mittels einer Kombination von wenigstens zwei dieser Ätztypen vor oder nach einem vorhergehenden Oberflächenpräparationsschritt des ersten Wafers mit dem Zweck des Verbindens oder Transplantierens durchgeführt wird.

10. Verfahren nach einem der vorhergehenden Ansprüche, wobei wenigstens einer von den zwei Wafern aus einem Halbleitermaterial hergestellt ist, beispielsweise aus Silizium oder aus einem Halbleitermaterial vom Typ III-V hergestellt ist, oder aus Germanium oder aus Germaniumsilizid (SiGe), oder aus einem piezoelektrischen Material oder aus einem isolierenden Material.

11. Verfahren nach einem der vorhergehenden Ansprüche, wobei der Abgratungsschritt in einer regulären Weise um den ersten Wafer herum durchgeführt wird, oder in einer irregulären Weise um den ersten Wafer herum derart, dass eine Ebene (44) erzeugt wird, oder eine Markierungszone (50, 51) erzeugt wird.

## Revendications

1. Procédé d'assemblage d'une première plaquette de volume (12, 22) et d'une deuxième plaquette de volume (14, 24), dont au moins la première plaquette de volume, connue sous le nom de plaquette chanfreinée, a au moins un bord chanfreiné (7, 17) comprenant :
- le recouvrement de la première plaquette avec une couche protectrice (18),
- une étape de rognage d'au moins une partie du bord chanfreiné de la première plaquette (12, 22) sur un largeur Ld, mesurée sur un plan parallèle à celui de la première plaquette, au moins égale à la largeur L du bord chanfreiné, mesurée sur le même plan et/ou au moins égale à la largeur de la zone de cette première plaquette qui ne peut pas, sans rognage, être liée à la deuxième plaquette, ledit rognage commençant à partir de ladite face de la première plaquette à assembler à la deuxième plaquette ;
- l'élimination de la couche protectrice (18) après rognage de la première plaquette,
- ensuite, une étape de liaison de la première plaquette, rognée, et de la deuxième plaquette.

2. Procédé selon la revendication 1, comprenant en outre, après la liaison, une étape d'amincissement d'au moins la première plaquette, laissant au moins une couche (16) sur la deuxième plaquette.

3. Procédé selon l'une des revendications 1 ou 2, l'étape de rognage étant réalisée :
- sur l'épaisseur entière e de la première plaquette,
- ou sur une épaisseur ed inférieure à l'épaisseur e de la première plaquette ;
- ou sur une épaisseur ed inférieure à l'épaisseur e de la première plaquette et supérieure ou égale à une épaisseur d'une couche (16, 28) de la première plaquette à transplanter sur la deuxième plaquette ;
- ou sur une épaisseur ed inférieure à l'épaisseur e de la première plaquette et inférieure ou égale à une épaisseur d'une couche (16, 28) de la première plaquette à transplanter ou transférer sur la deuxième plaquette ;
- et/ou sur une épaisseur ed de la première plaquette d'entre 1 µm et 100 µm.

4. Procédé selon l'une des revendications 1 à 3, la deuxième plaquette étant chanfreinée et comprenant au moins un bord chanfreiné (5).

5. Procédé selon l'une quelconque des revendications 1 à 4, l'étape de rognage de la première plaquette étant réalisée sur une largeur Ld, mesurée sur un plan parallèle à celui de la première plaquette, comprise entre 100 µm et 5 mm.

6. Procédé selon l'une quelconque des revendications précédentes,
la première plaquette ayant un plan de fragilisation (26) définissant une couche mince dans la plaquette, par exemple par implantation ionique ou par la création d'une interface de liaison amovible, la première plaquette étant rognée sur une épaisseur supérieure à celle de la couche mince,
l'étape d'assemblage étant éventuellement suivie :
- d'une étape d'amincissement par séparation de la première plaquette le long du plan de fragilisation, de façon à laisser la couche mince sur la deuxième plaquette et à laisser une portion libre (23) du premier substrat ;
- d'une nouvelle étape de création d'un nouveau plan de fragilisation dans la portion (23) du premier substrat qui est restée libre;
- d'une étape de liaison de cette portion (23) à un troisième substrat.

7. Procédé selon l'une quelconque des revendications 1 à 6, la première plaquette comprenant un épaulement latéral (25), éliminé pendant l'étape de rognage.

8. Procédé selon l'une quelconque des revendications 1 à 7, l'assemblage des deux substrats étant réalisé par adhérence moléculaire ou par liaison à l'aide d'une substance adhésive.

9. Procédé selon l'une quelconque des revendications précédentes, le rognage étant réalisé par gravure ou polissage mécanique ou chimique ou mécano-chimique ou par gravure au plasma ou par une combinaison d'au moins deux de ces types de gravure, avant, ou après, une étape préalable de préparation de surface de la première plaquette à des fins de liaison ou de transplantation.

10. Procédé selon l'une quelconque des revendications précédentes, au moins une des deux plaquettes étant réalisée en un matériau semi-conducteur, par exemple réalisée en silicium ou en un matériau semi-conducteur de type III-V, ou en germanium ou en siliciure de germanium (SiGe) ou en un matériau piézoélectrique ou en un matériau isolant.

11. Procédé selon l'une quelconque des revendications précédentes, l'étape de rognage étant réalisée de manière régulière autour de la première plaquette, ou de manière irrégulière autour de la première plaquette de façon à créer un plan (44) ou à créer une zone de marquage (50, 51).
